(19) **Europäisches Patentamt**
**European Patent Office**
**Office européen des brevets**

(11) **EP 2 172 526 B1**

(12) **EUROPEAN PATENT SPECIFICATION**

(45) Date of publication and mention
of the grant of the patent:
**09.11.2011 Bulletin 2011/45**

(51) Int Cl.:
***C09J 7/02*** *(2006.01)*

(21) Application number: **09171810.6**

(22) Date of filing: **30.09.2009**

(54) **Pressure-Sensitive Adhesive Sheet for Laser Processing and Method for Laser Processing**

Druckempfindliche Haftklebefolie für die Laserverarbeitung und Verfahren zur Laserverarbeitung

Feuille adhésive sensible à la pression pour traitement au laser et procédé de traitement au laser

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **01.10.2008 JP 2008255896**

(43) Date of publication of application:
**07.04.2010 Bulletin 2010/14**

(73) Proprietor: **Nitto Denko Corporation
Ibaraki-shi,
Osaka 567-8680 (JP)**

(72) Inventors:
• **Asai, Fumiteru
Ibaraki-shi Osaka (JP)**

• **Takahashi, Tomokazu
Ibaraki-shi Osaka (JP)**
• **Maekawa, Keiko
Ibaraki-shi Osaka (JP)**
• **Aoyagi, Kazuhiro
Ibaraki-shi Osaka (JP)**

(74) Representative: **Grünecker, Kinkeldey,
Stockmair & Schwanhäusser
Leopoldstrasse 4
80802 München (DE)**

(56) References cited:
**EP-A1- 1 634 673       EP-A1- 2 133 170
EP-A2- 1 061 108       EP-A2- 1 128 426
US-A1- 2002 187 357**

**Description**

The present invention relates to a pressure-sensitive adhesive sheet for laser processing, which is to be used at the time when a workpiece is laser-processed by a laser light having a wavelength of an ultraviolet region or a laser light enabling light absorption via multiphoton absorption process; and a method for laser processing.

With recent miniaturization and the like of electrical and electronic devices, their parts have been decreasing in size and increasing in fineness. Accordingly, there is a need for greater fineness and precision also in the cutting of various materials. In particular, in the semiconductor field where there is a great need for smaller size and higher density, attention in recent years has been directed to methods for cutting semiconductor wafers with a laser light, which causes little heat damage and allows high-precision processing.

As the above technique, there has been proposed a method including fixing to a dicing sheet a workpiece obtained by subjecting a substrate to various circuit formation and surface treating steps, and dicing the workpiece with a laser light to form small chips. As the dicing sheet to be used in such a method, there has been proposed a dicing sheet comprising a base including a base film and a pressuro-sensitive adhesive layer formed on a surface of the base, in which the pressure-sensitive adhesive layer is cut by the laser light without cutting the base film (e.g., see JP-A-2002-343747).

In the case where a laser light is employed for dicing the workpiece, a stress is imparted to the workpiece by ablation with the laser light and hence there occurs a so-called chip fry that separated pieces of the workpiece cannot be held on a pressure-sensitive adhesive sheet for laser processing to lose some pieces of the workpiece. Accordingly, there is a problem that the separated pieces of the workpiece cannot be efficiently collected.

In the case where the dicing sheet described in JP-A-2002-343747 is used, the pressure-sensitive adhesive layer is thermally cut by a fundamental wave (wavelength: 1064 nm) of YAG laser or a laser light of ruby laser (wavelength: 694 nm). Therefore, with the laser cutting, decomposition by thermal processing occurs not only at the upper layer of the pressure-sensitive adhesive layer but also at the inside of the pressure-sensitive adhesive layer or the interface between the base and the pressure-sensitive adhesive layer, so that processing of the pressure-sensitive adhesive layer in a transverse direction is apt to occur. Accordingly, the dicing sheet is insufficient for suppressing the chip fry of separated pieces of the workpiece.

EP-A-1128426 discloses a UV-curable pressure-sensitive adhesive composition comprising a photoinitiator which has a molar absorptivity at 365 nm of at least 1000 mol$^{-1}$·cm$^{-1}$ and a maximum absorption wavelength of at least 420 nm on a long wavelength side.

EP-A-1061108 discloses a low-staining adhesive sheet comprising a base film and an adhesive layer comprising a pressure-sensitive adhesive polymer on the base film, wherein the pressure-sensitive adhesive polymer is substantially free from oligomeric low-molecular weight matters.

US-A-2002/0187357 relates to a releasing sheet which comprises a sheet-like substrate and a cured layer placed thereon of an addition reaction type silicone composition containing a photosensitizer.

EP-A-2133170 teaches a pressure-sensitive adhesive sheet for laser processing that is used for laser processing of a workpiece with laser light having a wavelength in an ultraviolet region or with laser light that enables light absorption in an ultraviolet region that has passed a multiphoton absorption process.

EP-A-1634673 relates to a manufacturing method of laser-processed parts using a specific pressure-sensitive adhesive sheet.

An object of the present invention is to provide a pressure-sensitive adhesive sheet for laser processing and a method for laser processing, wherein separated pieces of a workpiece can be held on the pressure-sensitive adhesive sheet for laser processing, chip fry can be suppressed, and also the separated pieces of the workpiece can be efficiently collected.

As a result of extensive studies for solving the above problems, the present inventors have found that the above object can be achieved by the following pressure-sensitive adhesive sheet for laser processing and thus have accomplished the invention.

Namely, the present invention provides:

a pressure-sensitive adhesive sheet for laser processing, which comprises a base and a pressure-sensitive adhesive layer provided on one surface of the base,
said pressure-sensitive adhesive layer having an absorption coefficient at a wavelength of 355 nm of from 50 cm$^{-1}$ to 900 cm$^{-1}$,
said pressure-sensitive adhesive layer containing a light-absorbing agent in which an absorbance of the light-absorbing agent in a 0.01% by weight acetonitrile solution at a wavelength of 355 nm is from 0.01 to 1.20,
wherein the light-absorbing agent is a photoreactive polymerization initiator selected from the group consisting of 2-hydroxy-2-methyl-1-phenyl-propan-1-one,   1-[4-(2-hydroxyethoxy)-phenyl]-2-hydroxy-2-methyl-1-propan-1-one, and 2-hydroxy-1-{4-[4-(2-hydroxy-2-methyl-propionyl)-benzyl]phenyl} -2-methyl-propan-1-one; 2-(dimethylamino)-2-[(4-methylphenyl)methyl]-1-[4-(4-morpholinyl)phenyl]-1-butanone; and 2,4,6-trimethylbenzoyl-diphenyl-phosphine oxide, and
wherein the pressure-sensitive adhesive sheet is to be used at the time when a workpiece is laser-processed by a laser light having a wavelength of an ultraviolet region or a laser light enabling light absorption via multiphoton absorption process.

The present invention also provides:

a method for laser processing, which comprises:

attaching the pressure-sensitive adhesive sheet according to any one of claims 1 to 7 to a workpiece, and subsequently irradiating the workpiece with a laser light having a wavelength of an ultraviolet region or a laser light enabling light absorption via multiphoton absorption process from a surface opposite to the surface to which the pressure-sensitive adhesive sheet has been attached, thereby processing the workpiece by ablation.

Preferred embodiments are set forth in the subclaims.
FIG. 1 is a schematic view showing cross-section of a laminate processed by ultraviolet absorption ablation with a laser light
FIG. 2 is a schematic view showing an example of a dicing method of a semiconductor wafer in the invention.

Description of Reference Numerals and Signs

1    workpiece
2    pressure-sensitive adhesive sheet for laser processing
2a   pressure-sensitive adhesive layer
2b   base
3    laminate
4    adsorption stage
5    adsorption plate
6    laser light
7    semiconductor wafer
8    dicing flame

As the lasa to be used in the invention, in order not to deteriorate accuracy and appearance of edge of holes and cut wall surfaces of the workpiece by thermal damage at laser processing, a laser capable of ablation processing through ultraviolet ray absorption, which is non-thermal processing without passing through heat processing process, is employed
Specifically, there may be mentioned a laser with an oscillation wavelength of 400 nm or less, e.g., KrF excimer laser with an oscillation wavelength of 248 nm, XeCl excimer laser with an oscillation wavelength of 308 nm, and a third harmonic (355 nm) or a fourth harmonic (266 nm) of a YAG laser or, in case of a laser with an oscillation wavelength of 400 nm or more, a titanium sapphire laser with a wavelength from 750 nm to 800 nm, with pulse width of $1 \, e^{-9}$ second (0.000000001 second) or less capable of light absorption in an ultraviolet region via multiphoton absorption process and capable of cutting with a width of 20 $\mu$m or less by multiphoton absorption ablation. In particular, it is preferred to use a laser which allows focusing a laser light within a fine width of 20 $\mu$m or less and radiates an ultraviolet ray of 355 nm.
The workpiece is not particularly limited so long as it can be processed by ultraviolet absorption ablation with the laser light output by the above-mentioned laser. Examples thereof include various sheet materials, circuit boards, semiconductor wafers, glass substates, ceramic substrates, metal substrates, substrates for light-emitter or photoreceptor of semiconductor lasers or the like, substrates for MEMS (Micro Electro Mechanical System), semiconductor packages, fabrics, leathers, papers, and the like.
The pressure-sensitive adhesive sheet for laser processing of the invention can be suitably used particularly for processing sheet materials, circuit boards, semiconductor wafers, glass substrates, ceramic substrates, metal substrates, substrates for light-emitter or photoreceptor of semiconductor lasers, substrates for MEMS, or semiconductor packages.
Examples of the above-mentioned various sheet materials include polymer films and non-woven fabrics composed of a polyimide resin, a polyester resin, an epoxy resin, a urethane resin, a polystyrene resin, a polyethylene resin, a polyamide resin, a polycarbonate resin, a silicon resin, a fluorocarbon polymer, or the like; sheets to which a physical or optical function is imparted by drawing, impregnation, or the like of the resins; metallic sheets of cupper, aluminum, stainless steel, or the like; and laminates of the above-mentioned polymer films and/or metallic sheets directly or via an adhesive or the like.

Examples of the above-mentioned circuit boards include one-sided, double-sided, or multi-layered flexible printed boards; rigid boards composed of glass epoxy, ceramic, or metal core substrates; and optical circuit or optical-electric hybrid circuit boards formed on glass or polymers.

Examples of the forming material of the base include polyethylene terrephthalate, polyethylene naphthalate, polystyrene, polycarbonate, polyi,rnides, (meth)acrylic polymers, polyurethane-based resins, polynorbomene-based resins, polyalkylene glycol-based resins such as polyethylene glycol and polytetramethylene glycol, silicone-based rubbers, and polyolefine-based resins such as polyethylene, polypropylene, polybutadiene, polyvinyl alcohol, and polymethylpentene, but the forming material is not limited thereto.

Of these, it is preferred to use a polyolefin-based resin. Particularly, it is preferred to use an ethylene-vinyl acetate copolymer or a linear saturated hydrocarbon-based resin such as polyethylene or polypropylene. Since the etching rate of polyethylene having no functional group in the side chain thereof is extremely small and laser processability is particularly low, the generation of polyethylene decomposition products can be effectively suppressed.

The base may be monolayer or multilayer. Moreover, it may be in various forms such as film or mesh. Particularly, a base having a large void ratio, such as fibrous one, nonwoven fabric, woven fabric, or porous one or the above resin is suitable.

The thickness of the base can be optionally regulated within the range where operability and workability are not impaired in individual steps of attachment to the workpiece, cutting and boring of the workpiece, and peeling and collection of laser-processed articles but is usually 500 $\mu$m or less, preferably from 5 $\mu$m to 300 $\mu$m, and more preferably from 10 $\mu$m to 250 $\mu$m. In order to enhance adhesiveness and holding ability with adjacent material such as an absorption plate, the surface of the base may be subjected to conventional surface treatment, e.g., chemical or physical treatment such as treatment with chromic acid, exposure to ozone, exposure to flame, exposure to high-voltage electric shock, or ionized radiation treatment or coating treatment with an undercoat (e.g., pressure-sensitive adhesive substances to be mentioned below).

The absorption coefficient of the base at a wavelength of 355 nm is preferably 10 cm$^{-1}$ or less. Moreover, the base is preferably a base having at least one layer composed of polyethylene or polypropylene. Furthermore, the base is a base having at least one layer composed of a copolymer containing ethylene.

As the forming material of the pressure-sensitive adhesive layer, a known pressure-sensitive adhesive including a (meth)acrylic polymer or a rubber-based polymer can be used.

Examples of the monomer component forming the (meth)acrylic polymer include alkyl (meth)acrylates having a linear or branched alkyl group of 30 carbon atoms or less, preferably 3 to 18 carbon atoms, such as a methyl group, an ethyl group, an n-propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, or a dodecyl group. These alkyl (meth)acrylates may be used singly or two or more thereof may be used in combination.

Examples of the monomer component other than the above-mentioned monomer component include carboxyl group-containing monomers such as acrylic acid, methacrylic acid, carboxyethyl (meth)acrylate, carboxypentyl (meth) acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)aerylate, 4-hydroxybutyl (meth)acrylate, 6-hydroxyhexyl (meth)acrylate, 8-hydroxyoctyl (meth)acrytate, 10-hydroxydecyl (meth)acrylate, 12-hydroxylauryl (meth)acrylate, and (4-hydroxymethylcyclohexyl)methyl (meth)acrylate; sulfonic acid croup-containing monomers such as styrenesulfonic acid, allylsulfonic acid, 2-(meth)acrylamide-2-methylpropanesulfonic acid, (meth)acylamidopropanesulfonic acid, sulfopropyl (meth)acrylate, and (meth)acryloyloxynaphthalenesulfonic acid; and phosphoric acid group-containing monomers such as 2-hydroxyethyl acryloyl phosphate. These monomer components may be used singly or two or more thereof may be used in combination.

Moreover, for the purpose of crosslinking treatment of the (meth)acrylic polymer, a multifunctional monomer or the like can be also used as a copolymerization monomer component according to needs.

Examples of the multifunctional monomer include hexanediol di(meth)acrylate, (poly)ethylene glycol di(meth) acrylate, (poly)propylene glycol di(meth)acrylate, neopentyl glycol di(meth)acrylate, pentaerythritol di(meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol bexa(meth)acrylate, epoxy (meth)acrylate, polyester (meth)acrylate, and urethane (meth)acrylate. These multifunctional monomers may be used singly or two or more thereof may be used in combination.

The amount of the multifunctional monomer to be used is preferably 30% by weight or less, more preferably 20% by weight or less of the total monomer components from the viewpoint of pressure-sensitive adhesiveness and the like.

The preparation of the (meth)acrylic polymer can, for example, be performed by applying a suitable method such as a solution polymerization method, an emulsion polymerization method, a bulk polymerization method, or a suspension polymerization method on a mixture containing one or two or more monomer components.

Examples of a polymerization initiator include peroxides such as hydrogen peroxide, benzoyl peroxide, and t-butyl peroxide. The polymerization initiator is preferably used singly but may be also used as a redox polymerization initiator in combination with a reducing agent. Examples of the reducing agent include ionized salts such as sulfite salts, hydrogen sulfite salts, iron, copper, and cobalt salts, amines such as triethanolamine, and reducing sugars such as aldose and ketose. In addition, an azo compound is also a preferable polymerization initiator and 2,2'-axobis-2-methylpropioamidine acid salt, 2,2'-azobis-2,4-dimethylvalerontrile, 2,2'-azobis-N,N'-dimethylencisobutyramidine acid salt, 2,2'-azobisisobutyronitrile, 2,2.'-azobis-2-methyl-N-(2-hydroxyethyl)propionamide, and the like can be used. It is also possible to use two or more kinds of the polymerization initiators in combination.

The reaction temperature is usually from 50°C to 85°C and the reaction time is from 1 hour to 24 hours. Moreover, the solution polymerization is preferred among the abovo-mentioned production methods and, in general, a polar solvent such as ethyl acetate or toluene is used as a solvent for the (meth)acrylic polymer. The solution concentration is usually from 20% by weight to 80% by weight.

In order to enhance number-average molecular weight of the (mcth)acrylic polymer as a base polymer, a crosslinking agent may be suitably added to the pressure-sensitive adhesive. Examples of the crosslinking agent include polyisocyanate compounds, epoxy compounds, aziridine compounds, melamine resins, urea resins, anhydride compounds, polyamines, and carboxyl group-containing polymers. In the case where the crosslinking agent is used, generally, the amount is preferably from 0.01 part by weight to 10 parts by weight based on 100 parts by weight of the base polymer with considering that the pressure-sensitive adhesive force at peeling does not decrease too much. Moreover, in the pressure-sensitive adhesive which forms the pressure-sensitive adhesive layer, in addition to the above-mentioned components, conventional additives such as various tackifiers, antiaging agents, fillers, and colorants which are hitherto known can be incorporated.

In order to further improve peeling properties from the workpiece, the pressure-sensitive adhesive may be a radiation-curable pressure-sensitive adhesive which is cured with radiation ray such as an ultraviolet ray or an electron beam. In this connection, in the case where the radiation-curable pressure-sensitive adhesive is used as the pressure-sensitive adhesive, the pressure-sensitive adhesive layer is irradiated with a radiation ray after laser processing, so that the base is preferably one having a sufficient radiation ray transmittance.

As the radiation curable pressure-sensitive adhesive, one having a radiation curable functional group such as a carbon-carbon double bond and showing a pressure-sensitive adhesiveness can be used without particular limitation. Examples of the radiation curable pressure-sensitive adhesive include radiation curable pressure-sensitive adhesives in which a radiation curable monomer component or oligomer component is mixed into the aforementioned (meth)acrylic polymer.

Examples of the radiation curable monomer component or oligomer component to be mixed include urethane (meth)acrylate, trimethylolpropane tri(meth)acrylate, tetramethylolmethane tetra(meth)acrylate, pentaerythritol tri(meth) acrylate, pentaerythritol tetra(meth)acrylate, dipentaerythritol monohydmxypenta(meth)acrylate, dipentaerythritol hexa (meth)acrylate, and 1,4-butylene glycol di(meth)acrylate. They may be used singly or two or more thereof may be used in combination.

The amount of the radiation curable monomer component or oligomer component to be mixed is not particularly limited but, in consideration of adhesiveness, the amount is preferably from 5 parts by weight to 500 parts by weight, more preferably from 70 parts by weight to 150 parts by weight based on 100 parts by weight of the base polymer constituting the pressure-sensitive adhesive, such as the (meth)acrylic polymer.

Moreover, as the radiation curable pressure-sensitive adhesive, substance having a carbon-carbon double bond in the polymer side chain or main chain or at the main chain end can be also used as the base polymer. As such a base polymer, one having the (mcth)acrylic polymer as a fundamental skeleton is preferred. In this case, the radiation curable monomer component or oligomer component may be not particularly added and its use is optional.

In the radiation curable pressure-sensitive adhesive, a photoreactive polymerization initiator is contained 2-hydroxy-2-methyl-1-phenyl-propan-1-one, 1-[4-(2-hydroxycthoxy)-phenyl]-2-hydroxy-2-methyl-1-pmpan-1-one, and 2-hydroxy-1-{4-[4-(2-hydroxy-2-methyl-propionyl)-benzyl]phenyl}-2-methyl-propan-1-one; 2-(dimethylamino)-2-[(4-methylphenyl)methyl]-1-[4-(4-morpholinyl)phenyl]-1-butanone; and 2,4,6-trimethylbenzoyl-diphenyl-phosphine oxide.

The amount of the photoreactive polymerization initiator to be mixed is suitably selected from the range where the absorption coefficient of the pressure-sensitive adhesive layer at a wavelength of 355 nm becomes from 50 cm$^{-1}$ to 900 ce$^{-1}$ since the absorbance at a wavelength of 355 nm varies for every photoreactive polymerization initiator. The amount is preferably from 0.5 part by weight to 20 parts by weight based on 100 parts by weight of the base polymer. In the radiation curable pressure-sensitive adhesive, when the amount of the photoreactive polymerization initiator is less than 0.5 part by weight, curing of the pressure-sensitive adhesive by irradiation with a radiation ray becomes insufficient or uneven and thus decrease in pressure-sensitive adhesive force is limited. Moreover, when the amount exceeds 20 parts by weight, there arise problems of decrease in stability of the pressure-sensitive adhesive, increased contamination to articles to be cut, and the like. Using from 0.5 part by weight to 20 parts by weight of the photoreactive polymerization initiator based on 100 parts by weight of the base polymer, in order to adjust the absorption coefficient of the pressure-sensitive adhesive layer at a wavelength of 355 nm to from 50 cm$^{-1}$ to 900 cm$^{-1}$, the absorbance of the photoreactive polymerization initiator at a wavelength of 355 nm in a 0.01% by weight acetonitrile solution is from 0.01 to 1.20.

The pressure-sensitive adhesive sheet for laser processing according to the invention can be produced by applying a pressure-sensitive adhesive solution on the surface of the base and drying it (if necessary, heating to effect crosslinking) to form a pressure-sensitive adhesive layer. Moreover, there may be employed a method of separately forming a pressure-sensitive adhesive layer on a peeling liner and subsequently attaching the layer to the base. If necessary, a separator may be provided on the surface of the pressure-sensitive adhesive layer.

The pressure-sensitive adhesive layer preferably has a low content of low-molecular-weight substances from the viewpoint of prevention of contamination to the workpiece. Therefore, the weight-average molecular weight of the (meth)acrylic polymer is preferably 300,000 or more, more preferably from 400,000 to 3,000,000.

The thickness of the pressure-sensitive adhesive layer is suitably selected from the range where the layer is not peeled off the workpiece but is usually from 2 μm to 300 μm, preferably from 5 μm to 100 μm, and more preferably from 10 μm to 50 μm.

The pressure-sensitive adhesive force of the pressure-sensitive adhesive sheet for laser processing after ultraviolet irradiation is preferably from 0.05 N/20 mm to 2.0 N/20 mm, more preferably from 0.20 N/20 mm to 1.50 N/20 mm, and particularly preferably from 0.40 N/20 mm to 1.00 N/20 mm.

A separator is optionally provided for label processing or protection of the pressure-sensitive adhesive layer.

Examples of the constituting material of the separator include papers and films of synthetic resins such as polyethylene, polypropylene, and polyethylene terephthalate. In order to enhance the peeling ability from the pressure-sensitive adhesive layer, the surface of the separator may be subjected to peeling treatment such as silicone treatment, long-chain alkyl treatment, or fluorine treatment according to needs. Moreover, if necessary, the separator may be subjected to treatment for preventing ultraviolet transmission or the like so as to prevent the pressure-sensitive adhesive sheet from reacting with environmental ultraviolet rays. The thickness of the separator is usually from 10 μm to 200 μm, preferably from 25 μm to 100 μm.

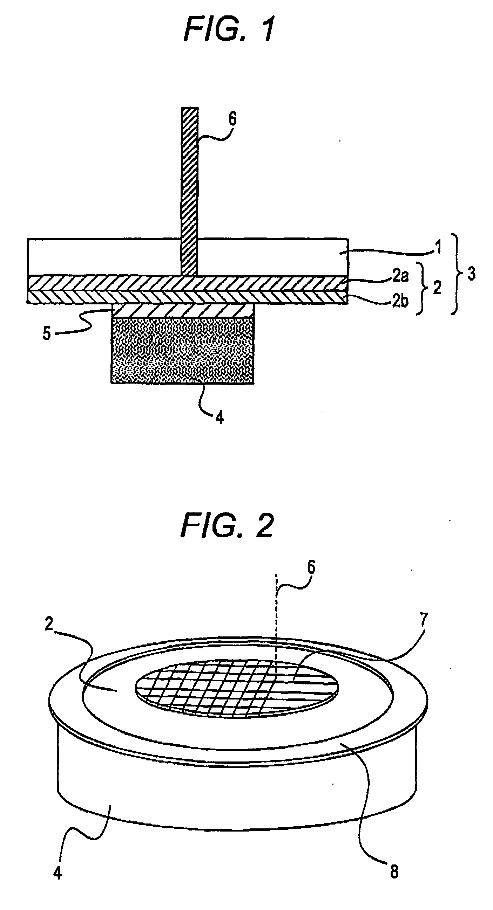

The following will describe the process for producing a laser-processed article by ultraviolet ablation with a laser light using the above-mentioned pressure-sensitive adhesive sheet for laser processing. For example, in the case of cutting, as shown in FIG. 1, a laminate 3 of a workpiece 1 and a pressure-sensitive adhesive sheet for laser processing 2 obtained by attaching the pressure-sensitive adhesive sheet 2 to the workpiece 1 by a known means such as a roll laminator or a press is placed on an adsorption plate 5 of an adsorption stage 4, a laser light 6 outputted from a predetermined laser oscillator is focused and applied on the workpiece 1 through a lens, and the laser irradiation position is transferred along a predetermined processing line to thereby perform cutting. The pressure-sensitive adhesive sheet for laser processing 2 to be provided on the laser light-emerging side of the workpiece 1 plays a role of supporting and fixing the workpiece 1 before laser processing and plays a role of preventing dropping of cut articles after laser processing. In this connection, a protective sheet may be provided on the laser light-entering side of the workpiece 1. The protective sheet is used for preventing attachment of decomposed matter and flying matter generated by laser processing of the workpiece 1 onto the surface of the workpiece 1.

As a transferring means of the laser light, a known laser processing method such as galvano scan or X-Y stage scan, or mask imaging processing is employed.

The conditions for laser processing are not particularly limited as far as the workpiece 1 is completely cut under the conditions. However, in order to avoid cutting the pressure-sensitive adhesive sheet for laser processing 2, it is preferred to adjust the energy condition within twice the energy condition under which the workpiece 1 is cut.

Moreover, a tab for cutting (cutting groove) can be made fine by focusing the beam diameter of the focusing part of the laser light. In order to achieve accuracy of cut edge, it is preferred to satisfy the following relationship:

$$\text{beam diameter } (\mu m) > 2 \times (\text{rate of transferring laser light } (\mu m/sec)/\text{repeating frequency of laser light } (Hz)).$$

In the case of cutting (dicing) of semiconductor wafers, as shown in FIG. 2, one surface of the semiconductor wafer 7 is attached to the pressure-sensitive adhesive sheet for laser processing 2 provided on the adsorption stage 4, a laser light 6 outputted from a predetermined laser oscillator is focused and applied on the semiconductor wafer 7 through a lens, and the laser irradiation position is transferred along a predetermined processing line to thereby perform cutting. As a transferring means of the laser light, a known laser processing method such as galvano scan or X-Y stage scan, or mask imaging processing is employed. The conditions for laser processing of a semiconductor wafer are not particularly limited as far as the semiconductor wafer 7 is completely cut and the pressure-sensitive adhesive sheet for laser processing 2 is not cut under the conditions. In this connection, a protective sheet may be provided on the laser light-entering side of the semiconductor wafer 7.

In such a dicing processing of the semiconductor wafers, individual semiconductor chips can be picked up and collected by a known method such as a method including cutting the wafer into individual semiconductor chips (laser-processed articles) and subsequently picking up them using a push-up pin called a needle by means of a conventionally known apparatus such as a die bonder, or a method shown in JP-A-2001-118862.

In the process for producing the laser-processed articles according to the invention, the laser-processed articles on the pressure-sensitive adhesive sheet are collected after completion of laser processing. The method for peeling them is not particularly limited and it is important not to impart a stress which permanently deform the laser-processed articles at peeling. Since the pressure-sensitive adhesive sheet of the invention has a small pressure-sensitive adhesive force, the laser-processed articles is not permanently deformed and can be easily peeled off. Moreover, in the case where a radiation curable pressure-sensitive adhesive is used for the pressure-sensitive adhesive layer of the pressure-sensitive adhesive sheet for laser processing 2, the pressure-sensitive adhesive layer is cured by irradiation with a radiation ray depending on the kind of the pressure-sensitive adhesive to decrease pressure-sensitive adhesiveness. Owing to irradiation with the radiation ray, the pressure-sensitive adhesiveness of the pressure-sensitive adhesive layer can be decreased by curing to facilitate the peeling. The means for the irradiation with radiation is not particularly limited but the irradiation is performed, for example, by irradiation with an ultraviolet ray.

Moreover, the removal of the decomposed matter through scattering can be efficiently achieved by blowing the laser-processed part with a gas such as helium, nitrogen, or oxygen. A protective sheet may be provided on the laser light-entering side of the workpiece 1.

Moreover, the pressure-sensitive adhesive sheet for laser processing according to the invention is also used for the production of laser-processed articles having various shapes, for example, boring by ultraviolet absorption ablation with a laser light.

Reference Examples

The following will specifically describe the invention with reference to Reference Examples.

Measurement of absorption coefficient

The absorption coefficients of a sheet-shaped pressure-sensitive adhesive and a base at a wavelength of 355 nm were measured by the following method. Using an ultraviolet visible spectrophotometer UV-2550 (manufactured by Shimadzu Cocporation), the sheet-shaped pressure-sensitive adhesive or the base was fixed to a jig and transmittance T (%) and reflectance R (%) at a wavelength of 355 nm were measured, followed by calculation according to the following equation,

$$T' = T/(100-R)$$

$$\text{Absorption coefficient (cm}^{-1}) = LN(1/T')/\text{thickness of sheet-shaped}$$

$$\text{pressure-sensitive adhesive or base (cm)}$$

Measurement of absorbance of light-absorbing agent

The absorbance of light-absorbing agent at a wavelength of 355 nm was measured by the following method. As an analyte to be measured, a solution diluted to 0.01% by weight with acetonitrile for spectroscopy (manufactured by Kishida Chemical Co., Ltd.) was used. A quartz glass cell (light path: 1 cm) containing the diluted solution was placed on the ultraviolet visible spectrophotometer UV-2550 (manufactured by Shimadzu Corporation) and the transmittance T (%) at a wavelength of 355 nm was measured, followed by calculation according to the following equation.

$$Absorbance = LOG(100/T)$$

Reference Example 1

An acrylic pressure-sensitive adhesive (1) was applied onto a base composed of an ethylene-vinyl acetate copolymer (thickness: 100 μm, absorption coefficient: 6.8 cm vinyl acetate content: 10%, melt mass flow rate: 9 g/10 min) and dried to form a pressure-sensitive adhesive layer, thereby obtaining a pressure-sensitive adhesive sheet for laser processing. The thickness of the pressure-sensitive adhesive layer was 20 μm and the absorption coefficient at a wavelength of 355 nm was 102.6 cm$^{-1}$.

In this regard, the acrylic pressure-scnsitive adhesive (1) was prepared by the following method. Fifty parts by weight of 2-ethylhexyl acrylate (2-EHA), 50 parts by weight of methyl acrylate (MA), and 10 parts by weight of acrylic acid (AA) were polymerized in ethyl acetate using 0.2 part by weight of a polymerization initiator, benzoyl peroxide (BPO) to obtain an acrylic polymer solution. One hundred parts by weight of the acrylio polymer. 3.5 parts by weight of an isocyanate crosslinking agent (Coronate L, manufactured by Nippon Polyurethane Industry Co., Ltd.), 50 parts by weight of a UV curable urethane acrylate oligomer (UV-1700B), and 5 parts by weight of a photoreactive polymerization initiator, 2,2-dimethoxy-1,2-diphenylethan-1-one (absorbance at a wavelength of 355 nm in a 0.01% by weight acetonitrile solution: 0.06) were added to toluene and were homogeneously dissolved with mixing.

The above-prepared pressure-sensitive adhesive sheet for laser processing was attached to one side of a silicon wafer having a thickness of 100 μm to prepare a silicon wafer fitted with a pressure-sensitive adhesive sheet Then, on an XY stage on which an adsorption plate made of a glass epoxy resin was placed, the wafer was disposed so that the workpiece was on top. The silicon wafer was cut by focusing a third harmonic (355 nm) of a YAG laser having a wavelength of 355 nm, an average output of 2.5 W, and a repeating frequency of 1 kHz through an fθ lens to the surface of the silicon wafer with a diameter of 25 mm, scanning the laser light at a rate of 2.5 mm/second by means of galvano scanner, and repeating the laser irradiation three times, thereby dicing into a chip size of 0.3 mm x 0.3 mm being achieved. The chip fry ratio on this occasion (disappearance ratio of chips after laser dicing) was 0%.

Reference Example 2

A silicon wafer fitted with a pressure-sensitive adhesive sheet was subjected to laser processing in the same manner as in Example I except that the amount of the photoreactive polymerization initiator to be added to the pressure-sensitive adhesive was changed to 9 parts by weight in Example 1. The thickness of the pressure-sensitive adhesive layer was 20 μm and the absorption coefficient at a wavelength of 355 nm was 197.9 cm$^{-1}$. The chip fry ratio was 0%.

Reference Example 3

A silicon wafer fitted with a pressure-sensitive adhesive sheet was subjected to laser processing in the same manner as in Example 1 except that 0.5 part by weight of 2-benzyl-2-dimethylammo-1-(4-morpholmophenyl)-butanone-1 (absorbance at a wavelength of 355 nm in a 0.01% by weight acetonitrile solution: 0.81) was used as a photoreactive polymerization initiator to be added to the pressure-sensitive adhesive in Example 1. The thickness of the pressure-sensitive adhesive layer was 20 μm and the absorption coefficient at a wavelength of 355 nm was 245.9 cm$^{-1}$. The chip fry ratio was 0%.

Reference Example 4

A silicon wafer fitted with a pressure-sensitive adhesive sheet was subjected to laser processing in the same manna as in Example 1 except that an acrylic pressure-sensitive adhesive (2) was used in Example 1. The thickness of the pressure-sensitive adhesive layer was 20 μm and the absorption coefficient at a wavelength of 355 nm was 833.1 cm$^{-1}$. The chip fry ratio was 0%.

The acrylic pressure-sensitive adhesive (2) was prepared by the following method. Seventy parts by weight of 2-methoxycthyl acrylate (2MEA), 30 parts by weight of acryloylmorpholine (ACMO), and 15 parts by weight of 2-hydroxyethyl acrylate (2HEA) were polymerized in ethyl acetate using 0.2 part by weight of a polymerization initiator, benzoyl peroxide (BPO) to obtain an acrylic polymer solution. Sixteen parts by weight of 2-methacryloyloxycthyl isocyanate (MOI) was reacted therewith to obtain a solution of an acrylic polymer having a carbon-carbon double bond in a side chain thereof. One hundred parts by weight of the acrylic polymer, 1 part by weight of an isocyanate crosslinking agent (Coronate L. manufactured by Nippon Polyurethane Industry Co., Ltd.), and 2 parts by weight of a photoreactive polymerization initiator, 2-benzyl-2-dimethylamino-1-(4-morpholinophenyl)-butanone-1 were added to toluene and were homogeneously dissolved with mixing.

Reference Example 5

A silicon wafer fitted with a pressure-sensitive adhesive sheet was subjected to laser processing in the same manner as in Example 1 except that an acrylic pressure-sensitive adhesive (3) was used in Example 1. The thickness of the pressure-sensitive adhesive layer was 20 $\mu$m and the absorption coefficient at a wavelength of 355 nm was 499 cm$^{-1}$. The chip fry ratio was 0%.

The acrylic pressure-sensitive adhesive (3) was prepared by the following method. Seventy parts by weight of 2-ethylhexyl acrylate (2EHA), 30 parts by weight of acryloylmorpholine (ACMO), and 15 parts by weight of 2-hydmxyethyl acrylate (2HEA) were polymerized in ethyl acetate using 0.2 part by weight of a polymerization initiator, benzoyl peroxide (BPO) to obtain an acrylic polymer solution. Ten pans by weight of 2-methacyloyloxyethyl isocyanate (MOI) was reacted therewith to obtain a solution of an acrylic polymer having a carbon-carbon double bond in a side chain thereof. One hundred parts by weight of the acrylic polymer, 1 part by weight of an isocyanate crosslinking agent (Coronate L, manufactured by Nippon Polyurethane Industry Co., Ltd.), and 2 parts by weight of a photoreactive polymerization initiator, 2-benzyl-2-dimethylamino-1-(4-morphounophenyl)-butaaone-1 were added to toluene and were homogeneously dissolved with mixing.

Comparative Example 1

A silicon wafer fitted with a pressure-sensitive adhesive sheet was subjected to laser processing in the same manner as in Example 1 except that 3 parts by weight of 2-benzyl-2-dimethylamino-1-(4-morpholinopenyl)-butanone-1 was used as a photoreactive polymerization initiator to be added to the pressure-sensitive adhesive in Example 1. The thickness of the pressure-sensitive adhesive layer was 20 $\mu$m and the absorption coefficient at a wavelength of 355 nm was 1006.8 cm$^{-1}$. The chip fry ratio was 78%.

Comparative Example 2

A silicon wafer fitted with a pressure-sensitive adhesive sheet was subjected to laser processing in the same manner as in Example 1 except that 0.5 part by weight of 1-[4-(2-hydroxycthoxy)-phenyl]-2-hydroxy-2-mcthyl-1-propone-1-one (absorbance at a wavelength of 355 nm in a 0.01% by weight acetonitrile solution: 0.05) was used as a photoreactive polymerization initiator in the acrylic pressure-sensitive adhesive (1) in Example 1. The thickness of the pressure-sensitive adhesive layer was 20 $\mu$m and the absorption coefficient at a wavelength of 355 nm was 15.4 cm$^{-1}$. The chip fry ratio was 19%.

As is apparent from the above Reference Examples and Comparative Examples, when the absorption coefficient of the prcssure-sensitive adhesive layer at a wavelength of 355 nm falls within the range of 50 cm$^{-1}$ to 900 cm$^{-1}$ and the absorbance of the light-absorbing agent, which is contained in the pressure-sensitive adhesive layer, in a 0.01% by weight acetonitrile solution at a wavelength of 355 nm falls within the range of 0.01 to 1.20, ablation processing by ultraviolet light absorption proceeds from the upper layer part to the lower layer part of the pressure-sensitive adhesive layer in sequence even after the laser light cut the workpiece and reaches the pressure-sensitive adhesive layer. Therefore, explosion of the pressure-sensitive adhesive layer and the base and processing of the pressure-sensitive adhesive layer in a transverse direction hardly occur and thus chip fry at laser dicing can be prevented. As a result, improvement in throughput by increasing laser power can be achieved. Moreover, since the laser-processed articles are not dropped out after processing, handling is easy. Furthermore, since low adhesiveness is realized by ultraviolet curing, peeling after processing is also easy.

**Claims**

1. A pressure-sensitive adhesive sheet for laser processing, which comprises a base and a pressure-sensitive adhesive layer provided on one surface of the base,
said pressure-sensitive adhesive layer having an absorption coefficient at a wavelength of 355 nm of from 50 cm$^{-1}$ to 900 cm$^{-1}$,
said pressure-sensitive adhesive layer containing a light-absorbing agent in which an absorbance of the light-absorbing agent in a 0.01 % by weight acetonitrile solution at a wavelength of 355 nm is from 0.01 to 1.20,
wherein the light-absorbing agent is a photoreactive polymerization initiator selected from the group consisting of 2-hydroxy-2-methyl-1-phenyl-propan-1-one, 1-[4-(2-hydroxyethoxy)-phenyl]-2-hydroxy-2-methyl-1-propan-1-one, and 2-hydroxy-1-{4-[4-(2-hydroxy-2-methyl-propionyl)-benzyl]phenyl}-2-methyl-propan-1-one; 2-(dimethylamino)-2-[(4-methylphenyl)methyl]-1-[4-(4-morpholinyl)phenyl]-1-butanone; and 2,4,6-trimethylbenzoyl-diphenyl-phosphine oxide, and

wherein the pressure-sensitive adhesive sheet is to be used at the time when a workpiece is laser-processed by a laser light having a wavelength of an ultraviolet region or a laser light enabling light absorption via multiphoton absorption process.

2. The pressure-sensitive adhesive sheet according to claim 1, wherein the pressure-sensitive adhesive layer comprises a pressure-sensitive adhesive containing an acrylic polymer.

3. The pressure-sensitive adhesive sheet according to claim 1 or 2, wherein the pressure-sensitive adhesive layer comprises an ultraviolet ray-curable pressure-sensitive adhesive.

4. The pressure-sensitive adhesive sheet according to any one of claims 1 to 3, wherein the pressure-sensitive adhesive layer comprises a pressure-sensitive adhesive containing an acrylic polymer having a carbon-carbon double bond in a side chain thereof.

5. The pressure-sensitive adhesive sheet according to any one of claims 1 to 4, wherein the base has an absorption coefficient at a wavelength of 355 nm of 10 cm$^{-1}$, or less.

6. The pressure-sensitive adhesive sheet according to any one of claims 1 to 5, wherein the base has a layer composed of polyethylene or polypropylene.

7. The pressure-sensitive adhesive sheet according to any one of claims 1 to 6, wherein the base has at least one layer composed of a copolymer containing ethylene.

8. Use of the pressure-sensitive adhesive sheet according to any of claims 1 to 7 in laser-processing of a semiconductor element.

9. A method for laser processing, which comprises:

attaching the pressure-sensitive adhesive sheet according to any one of claims 1 to 7 to a workpiece, and subsequently irradiating the workpiece with a laser light having a wavelength of an ultraviolet region or a laser light enabling light absorption via multiphoton absorption process from a surface opposite to the surface to which the pressure-sensitive adhesive sheet has been attached, thereby processing the workpiece by ablation.

10. The method for laser processing according to claim 9, wherein the workpiece is a semiconductor element, and the semiconductor element is separated into pieces by irradiation with the laser light to form a semiconductor chips.

**Patentansprüche**

1. Haftklebefolie zur Laserverarbeitung, welche einen Schichtträger und eine Haftkleberschicht, die auf einer Oberfläche des Schichtträgers vorgesehen ist, umfasst,

wobei die Haftkleberschicht einen Absorptionskoeffizienten bei einer Wellenlänge von 355 nm von 50 cm$^{-1}$ bis 900 cm$^{-1}$ aufweist,

wobei die Haftkleberschicht ein lichtabsorbierendes Mittel enthält, wobei eine Absorbanz des lichtabsorbierenden Mittels in einer 0,01 Gew.-% Acetonitrillösung bei einer Wellenlänge von 355 nm 0,01 bis 1,20 beträgt,

wobei das lichtabsorbierende Mittel ein fotoreaktiver Polymerisationsinitiator ist, der ausgewählt ist aus der Gruppe bestehend aus 2-Hydroxy-2-methyl-1-phenyl-propan-1-on, 1-[4-(2-Hydroxyethoxy)-phenyl]-2-hydroxy-2-methyl-1-propan-1-on, und 2-Hydroxy-1-{4-[4-(2-hydroxy-2-methyl-propionyl)-benzyl]phenyl}-2-methyl-propan-1-on; 2-(Dimethylamino)-2-[(4-methylphenyl)methyl]-1-[4-(4-morpholinyl)phenyl]-1-butanon; und 2,4,6-Trimethylbenzoyl-diphenyl-phosphin-oxid, und

wobei die Haftklebefolie zu der Zeit verwendet werden soll, wenn ein Werkstück mit einem Laserlicht mit einer Wellenlänge in einem Ultraviolettbereich oder mit einem Laserlicht, das Lichtabsorption über einen Multiphotonenabsorptionsprozess ermöglicht, Laser-verarbeitet wird.

2. Haftklebefolie nach Anspruch 1, wobei die Haftkleberschicht einen Haftkleber umfasst, der ein Acrylpolymer enthält.

3. Haftklebefolie nach Anspruch 1 oder 2, wobei die Haftkleberschicht einen durch Ultraviolettstrahlen härtbaren Haftkleber umfasst.

4. Haftklebefolie nach einem der Ansprüche 1 bis 3, wobei die Haftkleberschicht einen Haftkleber umfasst, der ein Acrylpolymer mit einer Kohlenstoff-Kohlenstoff-Doppelbindung in einer Seitenkette davon enthält.

5. Haftklebefolie nach einem der Ansprüche 1 bis 4, wobei der Schichtträger einen Absorptionskoeffizienten bei einer Wellenlänge von 355 nm von 10 cm$^{-1}$ oder weniger aufweist.

6. Haftklebefolie nach einem der Ansprüche 1 bis 5, wobei der Schichtträger eine aus Polyethylen oder Polypropylen zusammengesetzte Schicht aufweist.

7. Haftklebefolie nach einem der Ansprüche 1 bis 6, wobei der Schichtträger wenigstens eine Schicht, die aus einem Ethylen enthaltenden Copolymer zusammengesetzt ist, aufweist.

8. Verwendung der Haftklebefolie nach einem der Ansprüche 1 bis 7 bei der Laserverarbeitung eines Halbleiterelements.

9. Verfahren zur Laserverarbeitung, welches umfasst:

Befestigen der Haftklebefolie nach einem der Ansprüche 1 bis 7 an einem Werkstück, und anschließend Bestrahlen des Werkstücks mit einem Laserlicht mit einer Wellenlänge in einem Ultraviolettbereich oder mit einem Laserlicht, das Lichtabsorption über einen Multiphotonenabsorptionsprozess ermöglicht, von einer Oberfläche, die der Oberfläche, an der die Haftklebefolie befestigt worden ist, gegenüberliegt, wodurch das Werkstück durch Ablation verarbeitet wird.

10. Verfahren zur Laserverarbeitung nach Anspruch 9, wobei das Werkstück ein Halbleiterelement ist und das Halbleiterelement durch Bestrahlung mit dem Laserlicht in Stücke getrennt wird, um Halbleiterchips zu bilden.

**Revendications**

1. Feuille adhésive sensible à la pression pour traitement au laser, qui comprend une base et une couche adhésive sensible à la pression prévue sur une surface de la base, ladite couche adhésive sensible à la pression ayant un coefficient d'absorption à une longueur d'onde de 355 nm de 50 cm$^{-1}$ à 900 cm$^{-1}$, ladite couche adhésive sensible à la pression contenant un agent photo-absorbant dans lequel une absorbance de l'agent photo-absorbant dans une solution d'acétonitrile à 0,01 % en poids à une longueur d'onde de 355 nm est de 0,01 à 1,20, dans laquelle l'agent photo-absorbant est un initiateur de polymérisation photoréactif choisi dans le groupe constitué de la 2-hydroxy-2-méthyl-1-phényl-propan-1-one, la 1-[4-(2-hydroxyéthoxy)-phényl]-2-hydroxy-2-méthyl-1-propan-1-one, et la 2-hydroxy-1-{4-[4-(2-hydroxy-2-méthyl-propionyl)-benzyl]phényl}-2-méthyl-propan-1-one ; la 2-(diméthylamino)-2-[(4-méthylphényl)méthyl]-1-[4-(4-morpholinyl)phényl]-1-butanone ; et l'oxyde de 2,4,6-triméthylbenzoyl-diphényl-phosphine, et dans laquelle la feuille adhésive sensible à la pression est à utiliser à un moment où une pièce de fabrication est traitée au laser par une lumière laser ayant une longueur d'onde dans la région de l'ultraviolet ou une lumière laser permettant l'absorption de la lumière par un procédé d'absorption multiphotonique.

2. Feuille adhésive sensible à la pression selon la revendication 1, dans laquelle la couche adhésive sensible à la pression comprend un adhésif sensible à la pression contenant un polymère acrylique.

3. Feuille adhésive sensible à la pression selon la revendication 1 ou 2, dans laquelle la couche adhésive sensible à la pression comprend un adhésif sensible à la pression durcissable par rayonnement ultraviolet.

4. Feuille adhésive sensible à la pression selon l'une quelconque des revendications 1 à 3, dans laquelle la couche adhésive sensible à la pression comprend un adhésif sensible à la pression contenant un polymère acrylique ayant une double liaison carbone-carbone au niveau d'une chaîne latérale.

5. Feuille adhésive sensible à la pression selon l'une quelconque des revendications 1 à 4, dans laquelle la base a un coefficient d'absorption à une longueur d'onde de 355 nm inférieur ou égal à 10 cm$^{-1}$.

6. Feuille adhésive sensible à la pression selon l'une quelconque des revendications 1 à 5, dans laquelle la base possède une couche composée de polyéthylène ou de polypropylène.

7. Feuille adhésive sensible à la pression selon l'une quelconque des revendications 1 à 6, dans laquelle la base possède au moins une couche composée d'un copolymère contenant de l'éthylène.

8. Utilisation de la feuille adhésive sensible à la pression selon l'une quelconque des revendications 1 à 7 dans le traitement au laser d'un élément semi-conducteur.

9. Procédé de traitement au laser, qui comprend :

la fixation de la feuille adhésive sensible à la pression selon l'une quelconque des revendications 1 à 7 sur une pièce de fabrication, et
ensuite l'irradiation de la pièce de fabrication avec une lumière laser ayant une longueur d'onde dans la région de l'ultraviolet ou avec une lumière laser permettant l'absorption de la lumière par un procédé d'absorption multiphotonique à partir d'une surface opposée à la surface sur laquelle la feuille adhésive sensible à la pression a été fixée, en traitant ainsi la pièce de fabrication par ablation.

10. Procédé de traitement au laser selon la revendication 9, dans lequel la pièce de fabrication est un élément semi-conducteur, et l'élément semi-conducteur est séparé en fragments par irradiation avec la lumière laser pour former des puces de semi-conducteur.

# FIG. 1

# FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002343747 A
- EP 1128426 A
- EP 1061108 A
- US 20020187357 A
- EP 2133170 A
- EP 1634673 A
- JP 2001118862 A